Europäisches Patentamt

European Patent Office

Office européen des brevets

(19)

(11) Publication number: **0 398 654**
**A2**

# EUROPEAN PATENT APPLICATION

(21) Application number: **90305233.0**

(22) Date of filing: **15.05.90**

(51) Int. Cl.⁵: **G11C 11/00, G11C 16/06**

(30) Priority: **16.05.89 JP 122511/89**

(43) Date of publication of application:
**22.11.90 Bulletin 90/47**

(84) Designated Contracting States:
**DE FR GB**

(71) Applicant: **SEIKO EPSON CORPORATION**
**4-1, Nishishinjuku 2-chome**
**Shinjuku-ku Tokyo-to(JP)**

(72) Inventor: **Iwasaki, Takumi, c/o Seiko Epson**
**Corporation**
**3-5 Owa 3-chome**
**Suwa-shi, Nagano-ken(JP)**
Inventor: **Imai, Katsuaki, c/o Seiko Epson**
**Corporation**
**3-5 Owa 3-chome**
**Suwa-shi, Nagano-ken(JP)**

(74) Representative: **Caro, William Egerton et al**
**J. MILLER & CO. Lincoln House 296-302 High**
**Holborn**
**London WC1V 7JH(GB)**

(54) **Apparatus for writing data to an eeprom.**

(57) Apparatus for writing data to an EEPROM comprises an EEPROM (8) having a plurality of storage areas for data, and a RAM (3) for temporarily storing received data. The apparatus also comprises means (1) for establishing a difference between data stored in a respective storage area of the EEPROM and corresponding data stored in the RAM, and for selectively up-dating data stored in the storage areas in the EEPROM in accordance with said corresponding data.

Fig. 1

EP 0 398 654 A2

The present invention relates to apparatus for writing data to an EEPROM, and particularly to such apparatus for use in electronic equipment such as a printer and the like for storing therein data for setting an operating configuration or environment.

Equipment, such as a printer or the like, in which a micro-computer is incorporated as a control means needs data designating an operating configuration and an operating environment in order to achieve a predetermined function. For this purpose, the equipment usually incorporates therein an electrically erasable programmable read only memory or electrically re-writable read only memory (referred to as an "EEPROM", below) in which data input by way of a keyboard or a panel and relating to the operating configuration and the operating environment is stored.

An EEPROM is an optimum memory for storing therein data requiring infrequent re-writing, for example data designating an operating configuration for equipment such as a printer or the like, since such a memory needs no external power source for the back-up of data and further since it is electrically re-writable. However, an EEPROM requires a long time for the re-writing of data and also the total number of re-write cycles is restricted to about 10,000.

It is an object of the present invention to provide apparatus for re-writing an EEPROM, in which the time required for the re-writing of data may be reduced and which permits the life of the EEPROM to be prolonged.

According to the present invention, there is provided apparatus for writing data to an EEPROM, comprising an EEPROM having a plurality of storage areas for data, a RAM for temporarily storing received data, and characterised by means for establishing a difference between data stored in a respective storage area of the EEPROM and corresponding data stored in the RAM and for selectively up-dating data in the storage areas in the EEPROM in accordance with said corresponding data.

In a preferred embodiment, data stored in the RAM and data stored in the EEPROM are compared, and the EEPROM is up-dated only when such data does not coincide. As a result, it is possible to reduce the writing-in time since updating is avoided when it is unnecessary. Further, the number of complete writing-in cycles may be reduced whereby the overall life of the memory may be prolonged.

The present invention is described further, by way of example, with reference to the accompanying drawings, in which:-

Figure 1 is a block diagram illustrating an embodiment of apparatus according to the present invention for writing information to an EEPROM, applied to a printer;

Figure 2 is a diagram illustrating certain connections between a CPU and an EEPROM of the apparatus of Figure 1;

Figure 3 is a schematic diagram illustrating a data structure of the EEPROM;

Figure 4 (a) and Figure 4 (b) combine to provide a flow chart for illustrating the operation of the apparatus of Figure 1;

Figure 5 is a graph showing the relationship between the time required for re-writing data according to the present invention and the time required for re-writing data in conventional apparatus;

Figure 6 is a diagram illustrating a data structure of an EEPROM in a second embodiment of apparatus according to the present invention;

Figure 7 is a flow chart for illustrating the operation of the apparatus including the EEPROM of Figure 6;

Figure 8 is a diagram illustrating a data structure of an EEPROM in a third embodiment of apparatus according to the present invention; and

Figure 9 is a flow chart for illustrating the operation of the apparatus including the EEPROM of Figure 8.

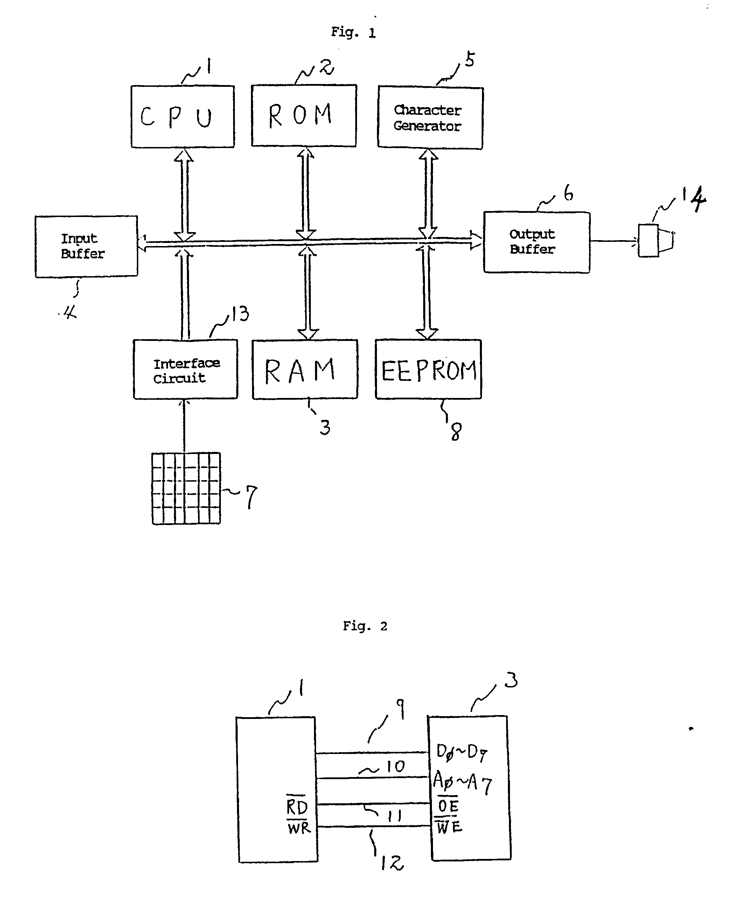

Figure 1 shows an embodiment of the present invention applied to a printer and comprising a central processing unit (CPU) 1 constituting a micro-computer which, together with a read only memory (ROM) 2 and a random access memory (RAM) 3, reads out dot pattern data corresponding to printing data received through an input buffer 4 in a character generator 5 and transfers the dot pattern data to an output buffer 6. A program stored in the ROM 2 enables data for setting an operating configuration received through a keyboard 7 to be stored in the RAM 3 in order to carry out printing in accordance with such data. An EEPROM 8 which stores initial data for setting the operating configuration is arranged to transfer or copy such data to the RAM 3 just after starting, and under an instruction from the CPU 1 subsequently to receive and store necessary data transferred from the RAM 3. An interface circuit 13 is provided between the keyboard 7 and the remainder of the apparatus, and the output of the buffer 6 is connected to a printing mechanism 14.

Figure 2 shows the connections between the CPU 1 and the EEPROM 8, data terminals $D_0$ to $D_7$ and address terminals $A_0$ to $A_7$ of each being connected with each other through buses 9 and 10, respectively, and read sand write terminals $\overline{RD}$ and $\overline{WR}$ of the CPU 1 being connected with output and write enable terminals $\overline{OE}$ and $\overline{WE}$ of the EEPROM 8 through control lines 11 and 12, respectively.

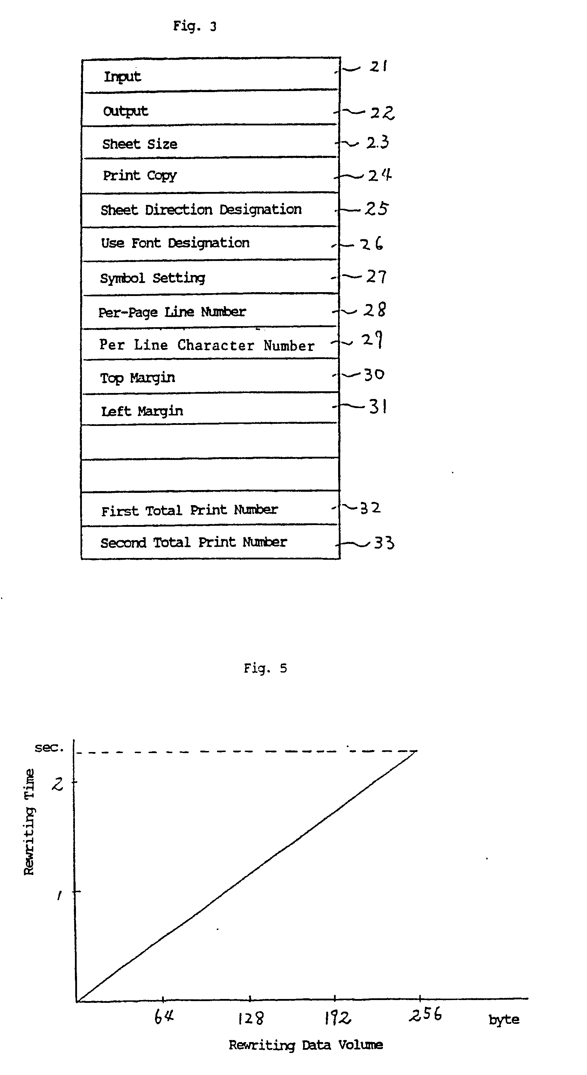

Figure 3 schematically shows the data structure of the above mentioned EEPROM, in which there are an input area 21, an output area 22, a sheet size area 23, a print copy number area 24, a sheet direction designating area 25, a use font designating area 26, a symbol setting area 27, a per page line number designating area 28, a per line character number designating area 29, a top margin size area 30 and a left margin size area 31. The EEPROM also has a first total print sheet number area 32 for integrating the number of sheets printed, and a second total print number area 33 for use as an auxiliary area when the number in the first print sheet number area 32 reaches a value representing the life of that area.

The first total print sheet number area 32 has sufficient capacity to store a numerical value, in binary notation, equal to the total number of re-write cycles of which the EEPROM is capable, for example 10,000. The second total print sheet number area 33 is arranged to store a numerical value, which is obtained by subtracting this total number storable in the first print sheet number area 32 from the current number of sheets printed.

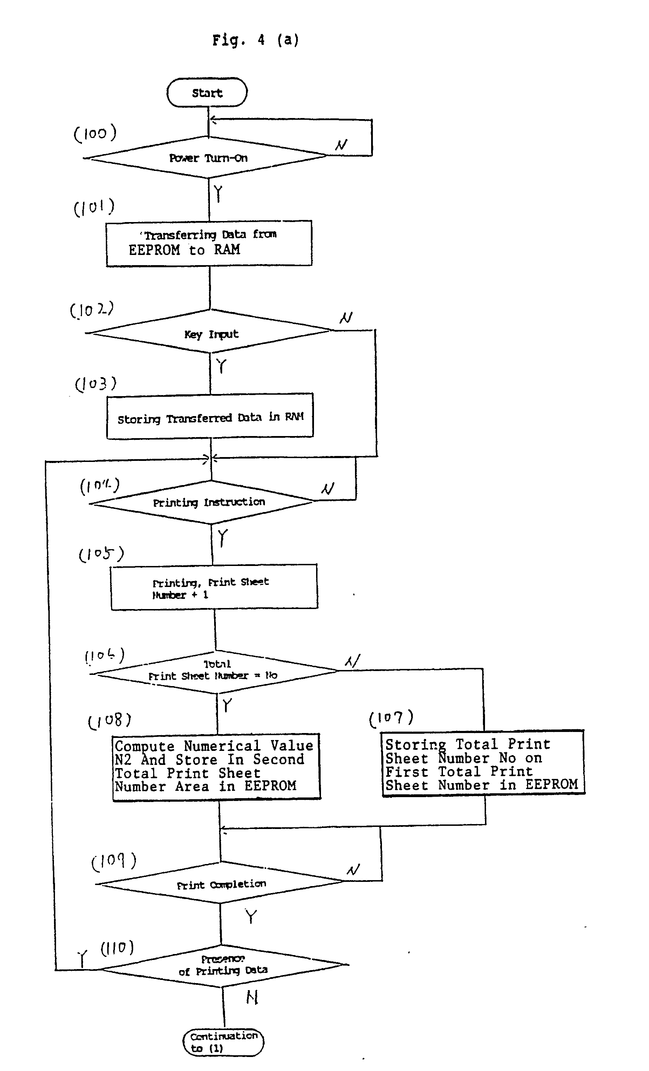

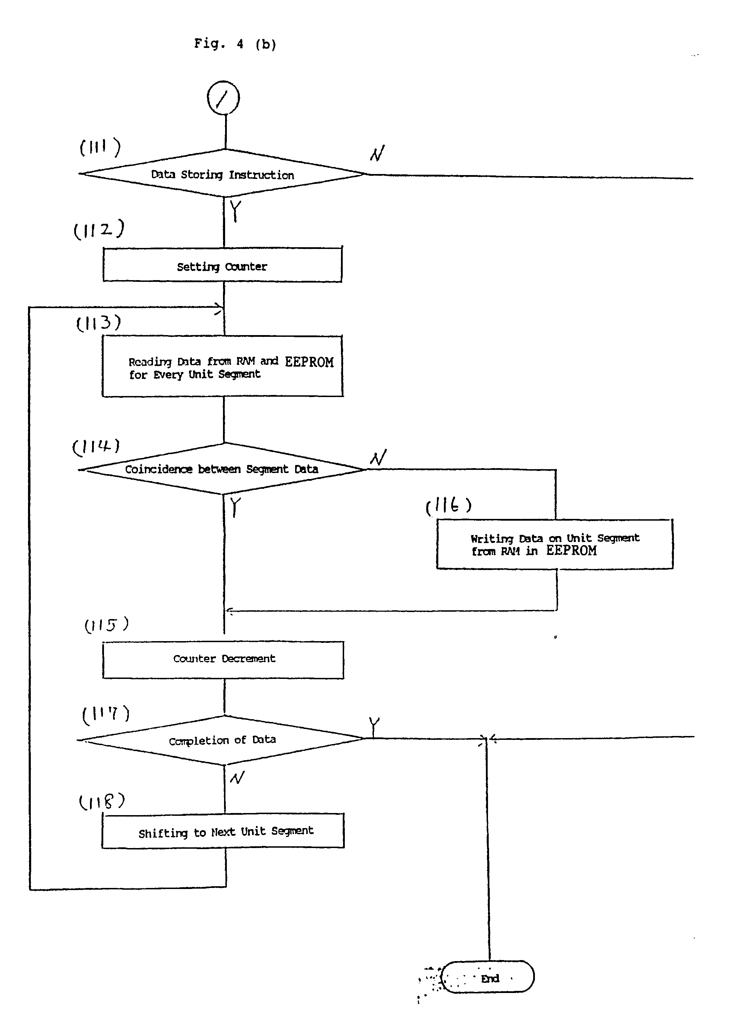

Next, an explanation of the operation of the apparatus will be given with reference to the flow chart shown in Figures 4 (a) and 4(b).

When a power source for the printer is turned on (Step 100), the CPU 1 reads out data stored in the EEPROM 8 as pre-set values and copies these values to the RAM 3 (Step 101). Accordingly, the printer can be operated under an environment set by these pre-set values. At this stage, if it is desired to change the operating configuration or the operating environment of the printer, data for an item to be changed, for example sheet size, is input through the keyboard 7 on the printer (Step 102) and the data for sheet size, which has been copied to the RAM 3 from the EEPROM 8, is replaced with the data input through the keyboard 7 (Step 103).

In this condition, when a start button is depressed to issue a printing instruction (Step 104), the CPU 1 operates the printing mechanism 14 in accordance with the data for setting the operating configuration now in the RAM 3. After the completion of printing a sheet, the CPU 1 computes the value for the total print sheet number obtained by adding "1" to a total print sheet number currently in the RAM 3 (Step 105). Then, the CPU 1 determines whether this value for the new total print sheet number is less than a specified value "No." or not (Step 106). If the new total print sheet number is less than the specified value "No.", this new total print sheet number is delivered to the first total print sheet number area 32 in the EEPROM 8 so as to up-date the data in this area (Step 107).

After the completion of printing for one page (Step 109), if further data to be printed exists (Step 110), the process from Step 104 is repeated again.

When printing for a predetermined number of sheets (Step 110) is completed and the user inputs a save instruction through the keyboard 7 to store the operating configuration just employed (Step 111), the CPU 1 first sets a data counter (Step 112) and then reads the data for setting the operating configuration stored in the RAM 3 and the eta for setting the operating configuration stored in the EEPROM 8 for each one of a pre-determined unit, for example each single byte (Step 113). The CPU 1 compares the two units of data with each other (Step 114) and, if the units of data coincide with each other, the CPU 1 makes a decrement in the count of the counter (Step 115) without re-writing the content of that unit in the EEPROM 8 and then shifts to the next unit (Steps 117 and 118), repeating the above mentioned process subsequent to Step 113.

Meanwhile, if, as a result of the above mentioned comparison, the data units are found to be different from each other (Step 114), the particular data unit in the EEPROM 8 is replaced with the particular unit in the RAM 3. Then, the counter is again decremented, following which the CPU 1 shifts to the next unit.

The above mentioned operation is carried out for every item. Since no re-write is made for data for the items in the EEPROM 8 which are coincident with those in the RAM 3, the time required for changing the data for setting the environment is shortened accordingly and also the number of re-write cycles occurring is reduced as far as possible, whereby she life of the EEPROM can be prolonged.

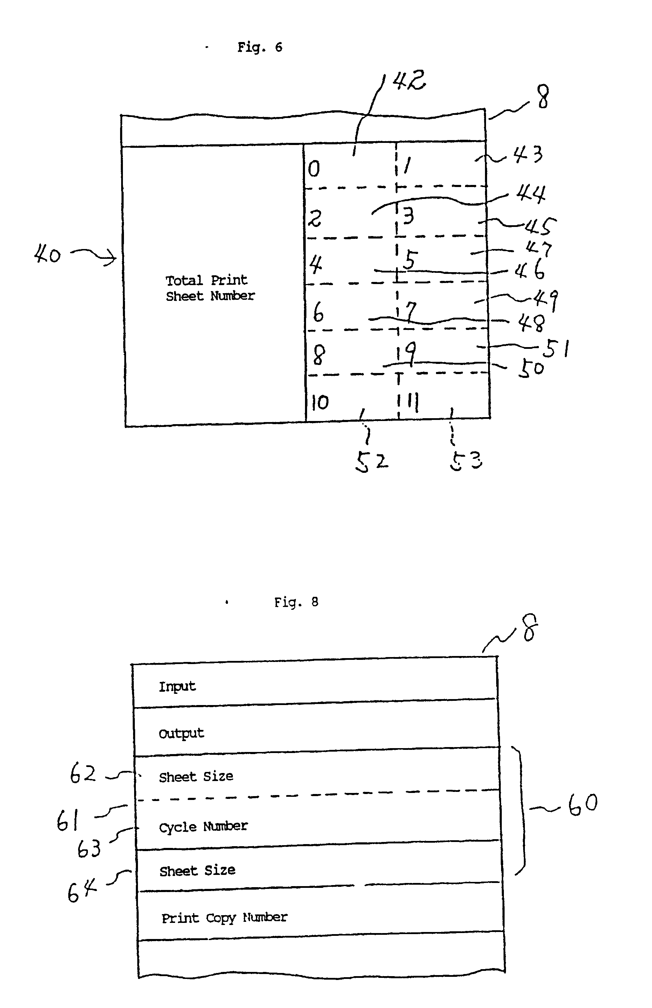

That is, with reference to Figure 5, the conventional apparatus re-writes all the data even though the data for only one unit is changed and, accordingly, a relatively long time is required for the re-writing (as shown by the chain line in Figure 5). By contrast, the present invention selectively re-writes only the changed data and, accordingly, the less the data to be re-written the shorter the time required for the re-writing can become (as shown by the solid line in Figure 5).

Once the total print sheet number reaches the specified value "No.", for example 10,000, (Step 106), the CPU 1 computes a numerical value N2, which is obtained by subtracting the specified numerical value "No." from the total print sheet number in the RAM 3, and stores this numerical value $N_2$ in the second total print sheet number area 33 in the EEPROM 8 (Step 108). Subsequently, each time that printing is carried out, the numerical value in the second total print sheet number area 33 is up-dated in proportion to the print sheet number in the RAM 3 while the data in the first total print sheet number area 32 is left fixed. With this arrangement, the integrating operation can be carried out without the data in the first total print sheet number area 32, whose re-writable life has expired, being re-written. It is noted here that when a display of the total print sheet number is required, the CPU 1 adds the data in the first total print sheet number area 32 to the data in the second total print sheet number area 33, and outputs the sum value thus obtained.

In the above described embodiment, the counting of the total print sheet number is carried out with the use of two areas. However, it is clear that the same technical effects and advantages can be obtained by using three or more areas and writing data to the next area when the number of re-write cycles of each has expired.

Figure 6 shows a variation of the data structure of Figure 3, in which a total print sheet number area 40 provided in the above mentioned EEPROM 8 is divided into a plurality of areas, that is a zero byte area 42 for the higher order digits of the total print sheet number, and a first byte area 43 to an eleventh byte area 53 for the lower order digits, all the areas 42 to 53 being stored with a "0" upon delivery from the manufacturer.

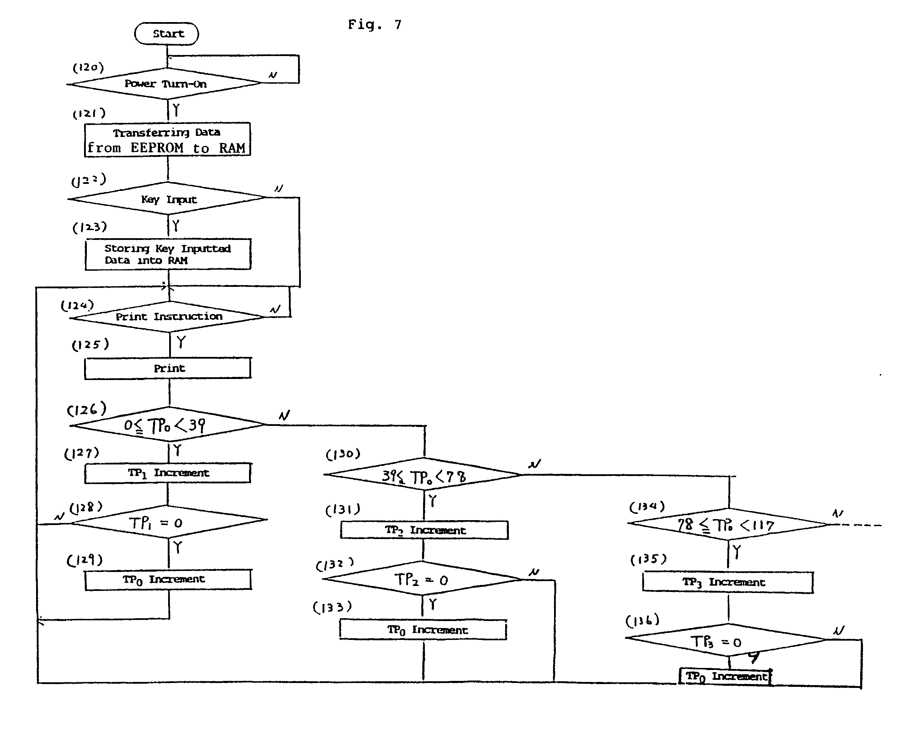

Next, an explanation of the operation of apparatus including such an EEPROM structure will be given with reference to the flow chart shown in Figure 7.

When the power source for the printer is turned on (Step 120), in a manner similar to the previous embodiment, the CPU 1 reads out data stored in the EEPROM 8 as pre-set values, and copies the same to the RAM 3 (Step 121). Accordingly, the printer can be operated under an environment set by the pre-set values. At this stage, if it is desired to change the operating configuration and the operating environment of the printer, data for an item to be changed, for example sheet size, is input through the keyboard 7 (Step 122), and the data for sheet size, which has been copied to the RAM 3 from the EEPROM 8, is replaced with the data input through the keyboard 7 (Step 123).

In this condition, when the start button is depressed to generate a printing instruction (Step 124), the CPU 1 operates the printing mechanism 14 in accordance with the data for setting the operating configuration now in the RAM 3 (Step 125).

After the printing of the first page is completed and since the data, TP0, in the 0-th byte area 42 is currently "0" (Step 126), the data, TP1, in the first byte area 43 is incremented by "1". Meanwhile, the data TP0 in the 0-th byte area 42 and the data in the second to eleventh byte areas 44 to 53 is maintained as "0". The process is repeated following the printing of each next page with the data TP1 in the first byte area 43 being incremented on each occasion until the data TP1 in the first byte area 43 becomes "256", and is then subjected to the next further increment. At this point, the data TP1 becomes "0" again (Step 128), and the data TP0 in the 0-th byte area 42 is changed from "0" to "1" (Step 129). When the next printing is carried out (Step 125), "1" is written as the data TP1 in the first byte area 43 (Step 127) and the process of incrementing the data TP0 is repeated. Subsequently, at the point at which the value in the first byte area again exceeds "256" and again becomes "0" (Step 128), the 0-th byte area 42 is incremented once more so as to write "2" therein. When the above mentioned process has been repeated by 38 cycle times, "39" is written in the 0-th byte area 42 at the stage at which the re-write cycle of the first byte area 43 has reached substantially the end of its useful life.

After the next printing, with the data TP0 being 39, the data, TP2, in the second byte area 44 is changed from "0" to "1". Thus, the data TP2 in the second byte area 44 is subjected to increment (Step 131) until the data TP2 in the second byte area 44 reaches "256". When the data TP2 in the second byte area 44 exceeds "256" and becomes "0" again (Step 132), the data TP0 in the 0-th byte area 42 is subjected to increment so as to write "40" therein. Subsequently, each time that the data TP2 in the second byte area 44 exceeds "256" and becomes "0", the data TP0 in the 0-th byte area 42 is subjected to increment (Step 133). At the time when the data TP0 in the 0-th byte area 42 becomes "78", that is when the write cycle of the second byte area 44 reaches the end of its useful life, the total print sheet number is stored using the third byte area 45 (Steps 134 to 136).

Subsequently, in a manner similar to that mentioned above, each time that the value written to one of the second to eleventh byte areas reaches "256" and becomes "0", the data TP0 in the 0-th byte area 42 is subjected to increment, and each time that the increment completes a 39th cycle, the operation of shifting to the next lower byte area 46 to 53 is repeated.

In order to display the total print sheet number, TP0 x 256 + TP1 is computed if the data TP0 in the 0-th byte area 42 is "0" to "38", while TP0 x 256 + TP2 is calculated if the data TP0 in the 0-th byte area 42 is "39" to "77", and further TP0 x 256 + TP3 is calculated if the data TP0 in the 0-th byte area 42 is "78" to "116".

With this arrangement, each byte area constituting a memory area can be used to the limit of its life, and, accordingly, the number of auxiliary memory areas to be prepared can be reduced as far as possible.

In particular, if a count of 10,000 requires two bytes, a count of 100,000 normally requires twenty bytes, that is ten times as large a capacity. However, in this embodiment, only twelve bytes are sufficient. That is, the capacity can be reduced by eight bytes.

It is noted that the 0-th byte area 42 indicating the higher order digits reaches "256" and is therefore up-dated to "0" in the course of writing in the seventh byte area 49 for one of the lower order digits. In this case, by setting up a flag, a variation in the higher order digits is detected so that it is possible to count a numerical value exceeding "256". Of course, only one bit is needed for the flag. In this way, the storage capacity can be greatly reduced in comparison with conventional total print sheet number counting systems.

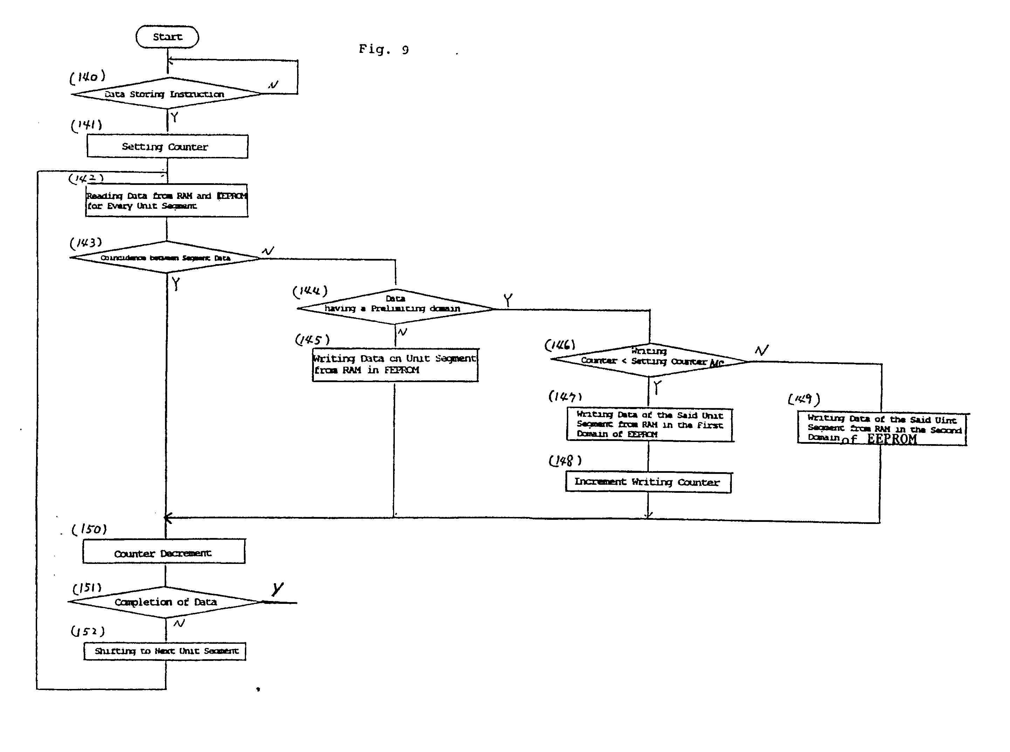

Figure 8 shows a further variation of the data structure of Figure 3, in which a storage area 60 in the EEPROM 8 for storing therein, for example, data having a frequency of up-dating greater than that of the other areas, such as data for sheet size or the like, is provided with two regions 61, 64 for such data, the region 61 being used first and including both a sheet size storage portion 62 and a count portion 63 for storing the number of re-write cycles therein.

Next, an explanation of the operation of apparatus including such an EEPROM will be given with reference to the flow chart shown in Figure 9.

As previously described, when an instruction is given for storing data for setting an environment (Step 140) after the completion of printing one document, the CPU 1 sets the counter (Step 141), and reads out data stored in the RAM 3 and data stored in the EEPROM 8 (Step 142) in order to compare the data (Step 143). The CPU 1 up-dates only that data in the EEPROM 8 which differs from the data in the RAM 3 (Step 145).

During this up-dating, if the sheet size is up-dated, that is if data in an area incorporating an auxiliary region is up-dated (Step 144), the CPU 1 increments data in the auxiliary cycle number portion 63 (Step 148) in association with the up-dating of data in the sheet size portion 62 (Step 147). In the case of a large number of up-dating cycles, when the data in the cycle number portion 63 reaches its re-writable life cycle number M0, for example 10,000 (Step 146), the CPU 1 stores further data for sheet size in the auxiliary sheet size region 64 during the next data up-dating cycle (Step 149).

Thereby, the region 61 having memory cells whose useful life has expired is excluded and the useful life of the entire EEPROM 8 is prolonged.

Subsequently, the CPU 1 shifts to the next items to be compared (Step 152), the counter being decremented (Step 150) as previously described.

As mentioned above, according to the present invention, there is provided an EEPROM in which storage areas for data to be stored are ensured, a RAM for temporarily storing externally input data, and means for comparing data from the EEPROM with data from the RAM for every unit segment and for storing data from the RAM in the EEPROM in the case of each unit segment having a difference. Accordingly, data from both memories are compared with each other, and then only those items or parts of the data having differences are selectively stored in the EEPROM, whereby it is possible firstly to reduce the writing time due to elimination of any up-dating of unnecessary data and secondly to aim at prolonging the life of the memory itself due to a decrease in the number of overall writing cycles occurring.

## Claims

1. Apparatus for writing data to an EEPROM, comprising an EEPROM (8) having a plurality of storage areas (21 to 33, 40, 60) for data, a RAM (3) for temporarily storing received data, and characterised by means (1) for establishing a difference between data stored in a respective storage area of the EEPROM and corresponding data stored in the RAM and for selectively up-dating data in the storage areas in the EEPROM in accordance with said corresponding data.

2. Apparatus according to claim 1 characterised in that the means for establishing a difference comprise means for comparing data stored in each storage area of the EEPROM with data stored in the RAM.

3. Apparatus according to claim 1 or 2 characterised in that at least one of the storage areas (60) in the EEPROM is sub-divided into two storage regions (61, 64).

4. Apparatus according to claim 3 characterised in that one of the storage regions (61) includes a data storage portion (62), and also a count storage portion (63) for storing a value representing the number of times that the data storage portion has been up-dated.

5. Apparatus according to any of claims 1 to 4 characterised in that the EEPROM has at least one additional storage area (32, 33, 42 to 53) for storing data representing an operation count for the apparatus.

6. A printer characterised by apparatus according to any preceding claim.

7. EEPROM write-in apparatus comprising an EEPROM (8) in which areas for storing data to be stored are ensured, a RAM (3) for temporarily storing data input externally, and means (1) for comparing data in said RAM with data in said EEPROM for every unit segment and storing data on a unit segment which has a difference into said EEPROM.

8. EEPROM write-in apparatus comprising an EEPROM (8) in which areas for storing data to be stored are ensured, a RAM (3) for temporarily storing data input externally, a means (1) for comparing data in said RAM with data in said EEPROM for every unit segment and for storing data on a unit segment which has a difference in said EEPROM, into said EEPROM, and a means including at least a plurality of areas (32, 33, 42 to 53) in which a total print sheet number is stored, for using a second area when an integrated value in a first area reaches a life cycle number.

9. EEPROM write-in apparatus comprising an EEPROM (8) in which areas for storing data to be stored are ensured, a RAM (3) for temporarily storing data input externally, and a means incorporating a plurality of areas (60) into which data having a large write-in cycle number are stored, among data to be stored under a storing instruction, including an area (63) on which a write-in cycle number is stored, at least on a first area side, for comparing data from said RAM with data from said EEPROM for every unit segment under a storing instruction and storing data on a unit segment which has a difference, into said EEPROM.

Fig. 1

Fig. 2

Fig. 3

| | |
|---|---|
| Input | — 21 |
| Output | — 22 |
| Sheet Size | — 23 |
| Print Copy | — 24 |
| Sheet Direction Designation | — 25 |
| Use Font Designation | — 26 |
| Symbol Setting | — 27 |
| Per-Page Line Number | — 28 |
| Per Line Character Number | — 29 |
| Top Margin | — 30 |
| Left Margin | — 31 |
| | |
| | |
| First Total Print Number | — 32 |
| Second Total Print Number | — 33 |

Fig. 5

Rewriting Time (sec.)

Rewriting Data Volume (byte)

Fig. 4 (a)

```
                    ( Start )
                       │
(100)                  │◄──────────────┐
      ╱───────────────╲               │ N
      ╲  Power Turn-On ╱───────────────┘
       ╲──────────────╱
              │ Y
(101)  ┌─────────────────────┐
       │ Transferring Data from
       │ EEPROM to RAM       │
       └─────────────────────┘
              │
(102)  ╱───────────────╲        N
       ╲   Key Input    ╱──────────────┐
        ╲──────────────╱               │
              │ Y                      │
(103)  ┌─────────────────────┐         │
       │ Storing Transferred  │         │
       │ Data in RAM          │         │
       └─────────────────────┘         │
  ┌───────────►├◄──────────────────────┘
  │
(104)  ╱───────────────╲        N
  │    ╲ Printing Instruction ╱────────┐
  │     ╲──────────────╱               │
  │           │ Y                      │
(105)  ┌─────────────────────┐         │
  │    │ Printing, Print Sheet│         │
  │    │ Number + 1           │         │
  │    └─────────────────────┘         │
  │           │                        │
(106)  ╱───────────────╲        N      │
  │    ╲ Total Print Sheet Number = No ╱┐
  │     ╲──────────────╱               ││
  │           │ Y                      ││
(108) ┌────────────────────────┐ (107)┌────────────────────┐
  │   │ Compute Numerical Value│ │ Storing Total Print    │
  │   │ N2 And Store In Second │ │ Sheet Number No on     │
  │   │ Total Print Sheet      │ │ First Total Print      │
  │   │ Number Area in EEPROM  │ │ Sheet Number in EEPROM │
  │   └────────────────────────┘ └────────────────────┘
  │           │◄───────────────────────┘
(109)  ╱───────────────╲        N
  │    ╲ Print Completion ╱──────────────┐
  │     ╲──────────────╱                 │
  │           │ Y                        │
(110)  ╱───────────────╲                 │
  └──Y─╲ Presence of Printing Data ╱◄────┘
        ╲──────────────╱
              │ N
       ( Continuation
         to (1) )
```

Fig. 4 (b)

(111) Data Storing Instruction — N

(112) Setting Counter

(113) Reading Data from RAM and EEPROM for Every Unit Segment

(114) Coincidence between Segment Data — N

(116) Writing Data on Unit Segment from RAM in EEPROM

(115) Counter Decrement

(117) Completion of Data

(118) Shifting to Next Unit Segment

End

Fig. 6

Fig. 8

**Fig. 7**

Fig. 9

```
                    ( Start )

(140)
            Data Storing Instruction          N

                        Y

(141)
            Setting Counter

(142)
        Reading Data from RAM and EEPROM
        for Every Unit Segment

(143)
        Coincidence between Segment Data       N

                        Y
                                    (144)
                                        Data
                                    having a Prelimiting domain      Y

                                            N
                        (145)                               (146)
                    Writing Data on Unit Segment                    Writing
                    from RAM in EEPROM                      Counter < Setting Counter MC       N

                                                    Y
                                    (147)                                       (149)
                                Writing Data of the Said Unit               Writing Data of the Said Uint
                                Segment from RAM in the First              Segment from RAM in the Second
                                Domain of EEPROM                          Domain of EEPROM

                                    (148)
                                Increment Writing Counter

(150)
            Counter Decrement

(151)
            Completion of Data                 Y

(152)          N
            Shifting to Next Unit Segment
```